# DEMANDE DE BREVET EUROPEEN

(11) **EP 4 310 924 A1**
(43) Date de publication de la demande: **24.01.2024**
(21) Numéro de dépôt: 23186196.4
(22) Date de dépôt: 18.07.2023
(51) Int. Cl.: H01L 31/049, H02S 30/10

(54) **MODULE PHOTOVOLTAÏQUE LÉGER COMPORTANT UN CADRE DE RENFORT COMPOSITE**

(30) Priorité: 18.07.2022 FR 2207348
(71) Demandeur: COMMISSARIAT À L'ÉNERGIE ATOMIQUE ET AUX ÉNERGIES ALTERNATIVES, 75015 Paris (FR)
(72) Inventeur: FRANCOIS, Jérome, 38054 GRENOBLE CEDEX 09 (FR); DE BETTIGNIES, Rémi, 38054 GRENOBLE CEDEX 09 (FR); DERBALI, Imed, 38054 GRENOBLE (FR)
(74) Mandataire: Brevalex

(57) **Abrégé**

L'objet principal de l'invention est un module photovoltaïque (1) obtenu à partir d'un empilement comportant au moins : une première couche (2), une pluralité de cellules photovoltaïques (4), un ensemble encapsulant (3) les cellules photovoltaïques (4), caractérisé en ce qu'il comporte en outre : une structure composite (10) formant un cadre pour le module photovoltaïque (1), comportant une couche intermédiaire (13) et un cadre de renfort composite (12), de rigidité plus élevée en superposition d'une ou plusieurs premières zones prédéterminées (P) de la couche intermédiaire (13), le cadre (12) présentant un module de Young supérieur à 10 GPa à 25°C. La structure composite est une structure de type sandwich, comprenant une couche principale formant l'âme (14) et deux première (13) et deuxième (16) couches de recouvrement formant des couches de peau, dont l'une est formée par la couche intermédiaire. L'âme (14) de la structure composite (10) est au moins en partie formée par une structure de faible densité inférieure à 500 kg/m3.

## Description

### Domaine technique

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

L'invention peut être mise en oeuvre pour de nombreuses applications, notamment des applications autonomes et/ou embarquées, étant particulièrement concernée par les applications qui requièrent l'utilisation de modules photovoltaïques légers, en particulier d'un poids par unité de surface inférieur à 5 kg/m², et de faible épaisseur, notamment inférieure à 5 mm. Elle peut ainsi notamment être appliquée pour des bâtiments tels que des habitats ou locaux industriels, par exemple pour la réalisation de leurs toitures, pour la conception de mobilier urbain, par exemple pour de l'éclairage public, la signalisation routière ou encore la recharge de voitures électriques, voire également être utilisée pour des applications nomades (mobilité solaire), en particulier pour une intégration sur des véhicules, tels que voitures, bus ou bateaux, des drones, des ballons dirigeables, entre autres.

L'invention propose ainsi un module photovoltaïque léger comportant un cadre de renfort composite intégré à la structure du module, ainsi qu'un procédé de réalisation d'un tel module photovoltaïque.

### Technique antérieure

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, notamment du verre trempé, présentant une épaisseur typiquement comprise entre 2 et 4 mm, classiquement de l'ordre de 3 mm.

La deuxième couche formant la face arrière du module photovoltaïque peut quant à elle être réalisée à base de verre, de métal ou de plastique, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 400 µm.

Les cellules photovoltaïques peuvent être reliées électriquement entre elles par des éléments de contact électrique avant et arrière, appelés conducteurs de liaison, et formés par exemple par des bandes de cuivre étamé, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques, ou bien encore uniquement en face arrière pour les cellules photovoltaïques de type IBC (pour « Interdigitated Back Contact » en anglais). Il est à noter que les cellules photovoltaïques de type IBC (« Interdigitated Back Contact ») sont des structures pour lesquelles les contacts sont réalisés sur la face arrière de la cellule en forme de peignes interdigités. Elles sont par exemple décrites dans le brevet américain US 4,478,879 A.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type thermodurcissable ou thermoplastique, et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 MPa et 400 MPa à température ambiante.

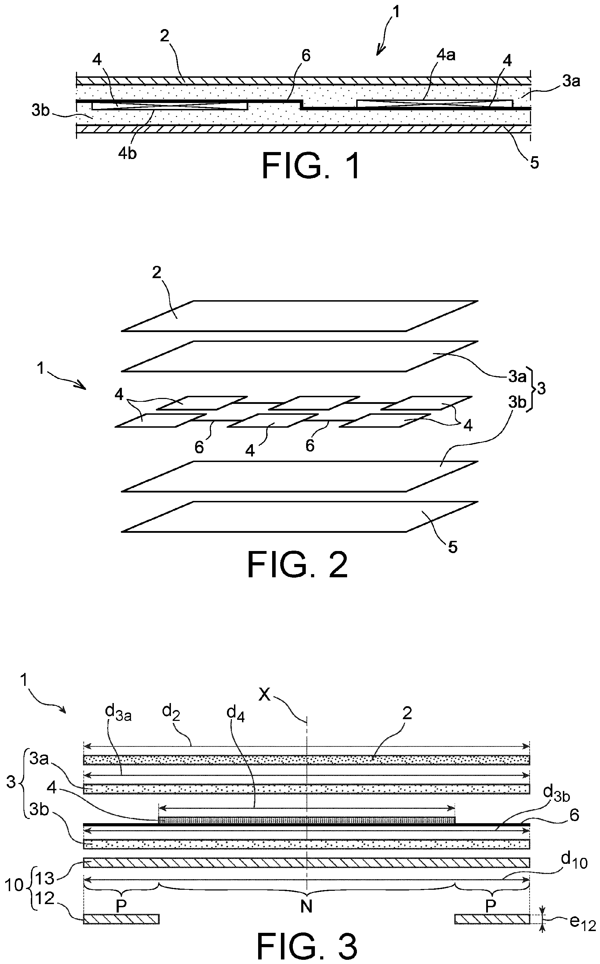

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une couche polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

De façon habituelle, le procédé de réalisation du module photovoltaïque 1 comporte une étape dite de lamination sous vide des différentes couches décrites précédemment, à une température supérieure ou égale à 120°C, voire 140°C, voire 145°C, voire encore 150°C, et inférieure ou égale à 170°C, voire 165°C, typiquement comprise entre 145°C et 165°C, et pendant une durée du cycle de lamination d'au moins 10 minutes, voire 15 minutes.

Pendant cette étape de lamination, les couches de matériau d'encapsulation 3a et 3b fondent et viennent englober les cellules photovoltaïques 4, en même temps que l'adhérence se crée à toutes les interfaces entre les couches, à savoir entre la face avant 2 et la couche avant de matériau d'encapsulation 3a, la couche de matériau d'encapsulation 3a et les faces avant 4a des cellules photovoltaïques 4, les faces arrière 4b des cellules photovoltaïques 4 et la couche arrière de matériau d'encapsulation 3b, et la couche arrière de matériau d'encapsulation 3b et la face arrière 5 du module photovoltaïque 1. Le module photovoltaïque 1 obtenu est ensuite encadré, typiquement par le biais d'un profilé en aluminium.

Une telle structure est maintenant devenue un standard qui possède une résistance mécanique importante grâce à l'utilisation d'une face avant 2 en verre épais et du cadre aluminium, lui permettant, notamment et dans la majorité des cas, de respecter les normes IEC 61215 et IEC 61730.

Néanmoins, un tel module photovoltaïque 1 selon la conception classique de l'art antérieur présente l'inconvénient d'avoir un poids élevé, en particulier un poids par unité de surface supérieur à 10 kg/m², voire 12 kg/m², et n'est ainsi pas adapté pour certaines applications pour lesquelles la légèreté est une priorité.

Ce poids élevé du module photovoltaïque 1 provient principalement de la présence du verre épais, avec une épaisseur d'environ 3 mm, pour former la face avant 2, la densité du verre étant en effet élevée, de l'ordre de 2,5 kg/m²/mm d'épaisseur, et du cadre aluminium.

Pour pouvoir résister aux contraintes lors de la fabrication et également pour des raisons de sécurité, par exemple du fait du risque de coupure, le verre est trempé. Or, l'infrastructure industrielle de la trempe thermique est configurée pour traiter du verre d'au moins 3 mm d'épaisseur. En outre, le choix d'avoir une épaisseur de verre d'environ 3 mm est également lié à une résistance mécanique à la pression normée de 5,4 kPa. En définitif, le verre représente ainsi à lui seul pratiquement 70 % du poids du module photovoltaïque 1, et plus de 80 % avec le cadre en aluminium autour du module photovoltaïque 1.

Aussi, afin d'obtenir une réduction significative du poids d'un module photovoltaïque pour permettre son utilisation dans de nouvelles applications exigeantes en termes de légèreté et de mise en forme, il existe tout d'abord un besoin pour trouver une solution alternative à l'utilisation d'un verre épais en face avant du module. Une des problématiques consiste donc à remplacer la face avant en verre par de nouveaux matériaux plastiques ou composites avec pour but premier la diminution importante du poids surfacique, ou grammage.

Ainsi, des feuilles de polymères, comme le polycarbonate (PC), le polyméthacrylate de méthyle (PMMA), le polyfluorure de vinylidène (PVDF), l'éthylène tétrafluoroéthylène (ETFE), l'éthylène chlorotrifluoroéthylène (ECTFE), ou l'éthylène propylène fluoré (FEP), peuvent représenter une alternative au verre. Cependant, lorsque seul le remplacement du verre par une telle feuille mince de polymères est envisagé, la cellule photovoltaïque devient très vulnérable au choc, à la charge mécanique et aux dilatations différentielles.

Une alternative est l'utilisation de matériaux composites à base de fibres de verre en face avant, en remplacement du verre standard. Le gain de poids peut être significativement important en dépit d'une moins bonne transparence.

Le remplacement du verre en face avant des modules photovoltaïques a fait l'objet de plusieurs brevets ou demandes de brevet dans l'art antérieur. On peut ainsi citer à ce titre les demandes de brevet FR 2 955 051 A1, FR 3 043 840 A1, FR 3 043 841 A1, FR 3 052 595 A1, FR 3 107 990 A1, la demande de brevet américain US 2005/0178428 A1 ou encore les demandes internationales WO 2008/019229 A2 et WO 2012/140585 A1. D'autres brevets ou demandes de brevet ont décrit l'utilisation de matériaux composites, comme par exemple la demande de brevet européen EP 2 863 443 A1, la demande de brevet français FR 3 106 698 A1, ou encore les demandes internationales WO 2018/076525 A1, WO 2019/006764 A1 et WO 2019/006765 A1.

Cependant, malgré les progrès réalisés, la légèreté des modules photovoltaïques reste à améliorer afin d'atteindre un poids surfacique inférieur à 5 kg/m² tout en économisant la matière utilisée en réduisant le volume utile du module.

Aussi, il existe également un besoin pour trouver une solution alternative à l'utilisation classique du cadre en aluminium avec pour objectif de diminuer le poids surfacique, ou grammage, du module photovoltaïque.

### Exposé de l'invention

L'invention a pour but de remédier au moins partiellement aux besoins mentionnés précédemment et aux inconvénients relatifs aux réalisations de l'art antérieur.

L'invention vise notamment à concevoir une solution alternative de module photovoltaïque prévu pour être léger afin de s'adapter à certaines applications, tout en présentant des propriétés mécaniques suffisantes lui permettant d'être résistant aux chocs et à la charge mécanique, et en particulier aux normes IEC 61215 et IEC 61730.

Elle vise en outre à améliorer la légèreté du cadre tout en permettant de rigidifier le module réalisé.

L'invention a ainsi pour objet, selon l'un de ses aspects, un module photovoltaïque obtenu à partir d'un empilement, formé selon un axe d'empilement vertical, comportant au moins :
- une première couche transparente formant la face avant du module photovoltaïque, destinée à recevoir un flux lumineux,
- une pluralité de cellules photovoltaïques disposées côte à côte et reliées électriquement entre elles,
- un ensemble encapsulant la pluralité de cellules photovoltaïques,
caractérisé en ce qu'il comporte en outre :
- une structure composite formant un cadre pour le module photovoltaïque, comportant au moins :
   - une couche intermédiaire,
   - un cadre de renfort composite, disposé au contact direct de la couche intermédiaire située entre le cadre de renfort composite et l'ensemble formé par la pluralité de cellules photovoltaïques et l'ensemble encapsulant,
      la rigidité du cadre de renfort composite étant plus élevée en superposition d'une ou plusieurs premières zones prédéterminées de la couche intermédiaire que la rigidité en superposition d'une ou plusieurs deuxièmes zones prédéterminées de la couche intermédiaire,
      le cadre de renfort composite présentant un module de Young supérieur à 10 GPa à 25°C, l'ensemble encapsulant la pluralité de cellules photovoltaïques étant situé au moins en partie entre ladite première couche et ladite structure composite.

Le terme « transparent » signifie que la première couche formant la face avant du module photovoltaïque est au moins partiellement transparente à la lumière visible, laissant passer au moins environ 80 % de cette lumière.

En particulier, la transparence optique, entre 300 nm et 1200 nm, de la première couche formant la face avant du module photovoltaïque peut être supérieure à 80 %. De même, la transparence optique, entre 300 nm et 1200 nm, de l'ensemble encapsulant peut être supérieure à 90 %.

En outre, par le terme « encapsulant » ou « encapsulé », il faut comprendre que la pluralité de cellules photovoltaïques est disposée dans un volume, par exemple hermétiquement clos vis-à-vis des liquides, au moins en partie formé par au moins deux couches de matériau(x) d'encapsulation, réunies entre elles après lamination pour former l'ensemble encapsulant.

En effet, initialement, c'est-à-dire avant toute opération de lamination, l'ensemble encapsulant est constitué par au moins deux couches de matériau(x) d'encapsulation, dites couches de coeur, entre lesquelles la pluralité de cellules photovoltaïques est encapsulée. Toutefois, pendant l'opération de lamination des couches, les couches de matériau d'encapsulation fondent pour ne former, après l'opération de lamination, qu'une seule couche (ou ensemble) solidifiée dans laquelle sont noyées les cellules photovoltaïques.

Par ailleurs, grâce à l'invention, il peut être possible d'obtenir un nouveau type de module photovoltaïque léger qui, par l'utilisation d'un cadre composite en remplacement du cadre en aluminium classique, peut présenter un poids surfacique inférieur à 5 kg/m², tout en permettant de rigidifier le module, notamment une augmentation de la rigidité globale en flexion du module. Le cadre composite est par ailleurs avantageusement plus léger qu'une simple couche intermédiaire, ce qui permet un gain en masse.

Le module photovoltaïque selon l'invention peut en outre comporter l'une ou plusieurs des caractéristiques suivantes prises isolément ou suivant toutes combinaisons techniques possibles.

La ou les premières zones prédéterminées peuvent comporter la périphérie de la couche intermédiaire, ou encore le pourtour de la couche intermédiaire.

La ou les premières zones prédéterminées peuvent encore comporter une ou plusieurs zones transversales de la couche intermédiaire, s'étendant notamment d'un bord à un autre de la couche intermédiaire, notamment perpendiculairement ou non, et/ou d'un angle à un autre de la couche intermédiaire, formant notamment une forme de croix de rigidification.

Dans un exemple de réalisation, la première couche peut être au moins en partie formée par un matériau composite comprenant une résine polymère et des fibres.

Dans un exemple de réalisation, la couche intermédiaire et/ou le cadre de renfort composite peuvent être au moins en partie formés par un matériau composite comprenant une résine polymère et des fibres.

Les fibres peuvent notamment être des fibres de verre, de carbone, d'aramide et/ou des fibres naturelles, notamment de chanvre, de lin et/ou de basalte, notamment sous la forme de tissus, par exemple tissés, non tissés et/ou cousus, notamment sous la forme d'un ou plusieurs plis, par exemple entre 1 et 6 plis.

La résine polymère peut notamment être choisie parmi : le polyuréthane (PU), le polypropylène (PP), l'époxy, le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE) et/ou l'éthylène propylène fluoré (FEP), entre autres.

La première couche peut être au moins en partie formée par un matériau composite comprenant des fibres de verre imprégnées de résine polymère.

En outre, le cadre de renfort composite peut présenter un module de Young compris entre 20 GPa et 100 GPa à 25°C, voire entre 80 GPa et 100 GPa à 25°C ou bien encore entre 20 GPa et 50 GPa à 25°C.

La dimension transversale par rapport à l'axe d'empilement vertical de la structure composite peut être avantageusement supérieure à la dimension transversale par rapport à l'axe d'empilement vertical de la pluralité de cellules photovoltaïques.

Selon une première variante, le cadre de renfort composite peut comporter une structure monolithique discontinue en superposition de la ou des premières zones prédéterminées de la couche intermédiaire. La ou les deuxièmes zones prédéterminées de la couche intermédiaire peuvent ne pas être recouverte(s) par le cadre de renfort composite. Le cadre de renfort composite peut présenter la même rigidité que celle de la couche intermédiaire et être constitué par le même matériau que celui de la couche intermédiaire.

Selon une deuxième variante, la structure composite peut comporter une structure multicouche, notamment avec une épaisseur du cadre de renfort composite plus élevée en superposition d'une ou plusieurs premières zones prédéterminées de la couche intermédiaire que l'épaisseur en superposition d'une ou plusieurs deuxièmes zones prédéterminées de la couche intermédiaire.

La structure composite peut être une structure de type sandwich, comprenant une couche principale formant l'âme et deux première et deuxième couches de recouvrement formant des couches de peau, dont l'une est formée par la couche intermédiaire, notamment constituées d'un ou plusieurs plis, disposées de part et d'autre de l'âme de sorte que l'âme soit prise en sandwich entre les deux couches de peau.

Selon une réalisation, l'âme de la structure composite peut être de section rectangulaire ou trapézoïdale dans un plan comprenant l'axe vertical.

L'âme de la structure composite peut être au moins en partie formée par une structure de faible densité inférieure à 500 kg/m³, par exemple 100 kg/m³, notamment une structure alvéolaire telle qu'une mousse faible densité, par exemple en polyuréthane (PU), en polychlorure de vinyle (PVC) et/ou polytéréphtalate d'éthylène (PET), un nid d'abeilles, du bois, du balsa et/ou du liège.

L'âme de la structure composite peut encore correspondre à du vide.

Les couches de peau peuvent être au moins en partie formées par un matériau composite comprenant une résine polymère et des fibres, notamment des fibres de verre, de carbone, d'aramide et/ou des fibres naturelles, notamment de basalte, notamment sous la forme de tissus, par exemple tissés, non tissés et/ou cousus, notamment sous la forme d'un ou plusieurs plis, par exemple entre 1 et 6 plis.

En outre, l'âme de la structure composite peut être située en superposition de la ou des premières zones prédéterminées de la couche intermédiaire. La ou les deuxièmes zones prédéterminées de la couche intermédiaire peuvent être non recouvertes ou bien alors recouvertes par la deuxième couche de recouvrement, autre que la couche intermédiaire.

Par ailleurs, selon une variante, le cadre de renfort composite peut être une structure de type tubulaire, comprenant un corps creux composite, notamment de section rectangulaire ou carrée dans un plan comprenant l'axe vertical.

De plus, le module photovoltaïque peut comporter un câble de connexion électrique, ou sortie câble, relié à un ou plusieurs conducteurs de liaison reliant les cellules photovoltaïques entre elles, et traversant l'âme de la structure composite, éventuellement aménagée pour permettre le passage du câble de connexion électrique, de manière à permettre la connexion électrique du module photovoltaïque et/ou le rattachement électrique à un autre module photovoltaïque.

L'âme de la structure composite peut loger au moins une diode de bypass connectée au câble de connexion électrique.

Par ailleurs, l'ensemble encapsulant peut être formé par au moins une couche avant et une couche arrière comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée.

L'ensemble encapsulant peut présenter une épaisseur comprise entre 200 µm et 600 µm, notamment entre 400 µm et 600 µm. De plus, l'ensemble encapsulant peut présenter un module de Young compris entre 2 MPa et 400 MPa à 25°C, voire entre 2 MPa et 200 MPa à 25°C.

En outre, l'invention a encore pour objet, selon un autre de ses aspects, un procédé de réalisation d'un module photovoltaïque tel que défini précédemment, à partir d'un empilement, formé selon un axe d'empilement vertical, comportant :
- une première couche transparente formant la face avant du module photovoltaïque, destinée à recevoir un flux lumineux,
- une pluralité de cellules photovoltaïques disposées côte à côte et reliées électriquement entre elles,
- un ensemble encapsulant la pluralité de cellules photovoltaïques,
- une structure composite formant un cadre pour le module photovoltaïque, comportant au moins :
   - une couche intermédiaire,
   - un cadre de renfort composite, disposé au contact direct de la couche intermédiaire située entre le cadre de renfort composite et l'ensemble formé par la pluralité de cellules photovoltaïques et l'ensemble encapsulant, la rigidité du cadre de renfort composite étant plus élevée en superposition d'une ou plusieurs premières zones prédéterminées de la couche intermédiaire que la rigidité en superposition d'une ou plusieurs deuxièmes zones prédéterminées de la couche intermédiaire,
      le cadre de renfort composite présentant un module de Young supérieur à 10 GPa à 25°C, l'ensemble encapsulant la pluralité de cellules photovoltaïques étant situé au moins en partie entre ladite première couche et ladite structure composite,
      le procédé comportant l'étape de fabrication du module photovoltaïque par un procédé de lamination, d'infusion, de moulage par transfert de résine (ou encore RTM pour « Resin Transfer Molding » en anglais) et/ou de consolidation de préimprégnés, de sorte à ce que le cadre de renfort composite soit intégré à l'intérieur du module photovoltaïque.

L'étape de fabrication peut comporter une étape de lamination à chaud et sous vide réalisée à une température supérieure ou égale à 120°C, voire 130°C, voire 140°C, voire 145°C, voire encore 150°C, et inférieure ou égale à 180°C, voire 170°C, voire 165°C, typiquement comprise entre 130°C et 180°C, voire entre 145°C et 165°C, et pendant une durée du cycle de lamination d'au moins 5 minutes, voire 10 minutes, voire 15 minutes, notamment comprise entre 5 et 20 minutes.

Le module photovoltaïque et le procédé de réalisation selon l'invention peuvent comporter l'une quelconque des caractéristiques précédemment énoncées, prises isolément ou selon toutes combinaisons techniquement possibles avec d'autres caractéristiques.

### Brève description des dessins

L'invention pourra être mieux comprise à la lecture de la description détaillée qui va suivre, d'exemples de mise en oeuvre non limitatifs de celle-ci, ainsi qu'à l'examen des figures, schématiques et partielles, du dessin annexé, sur lequel :
La Figure 1 représente, en coupe, un exemple classique de module photovoltaïque comportant des cellules photovoltaïques cristallines,
La Figure 2 représente, en vue éclatée, le module photovoltaïque de la figure 1,
Les Figures 3 à 7 illustrent, en coupe, différents exemples de réalisation de modules photovoltaïques conformes à l'invention, et
Les Figures 8 à 10 illustrent, selon des vues du dessous, différents positionnements possibles pour le cadre de renfort composite sur la couche intermédiaire pour un module photovoltaïque conforme à l'invention.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### Exposé détaillé de l'invention

Les figures 1 et 2 ont déjà été décrites dans la partie relative à l'état de la technique antérieure.

Les figures 3 à 10 permettent d'illustrer différents modes de réalisation de modules photovoltaïques 1 conformes à l'invention.

On considère ici que les cellules photovoltaïques 4, interconnectées par des rubans 6 en cuivre étamé soudés, semblables à ceux représentés aux figures 1 et 2, sont des cellules « cristallines », c'est-à-dire qu'elles comportent du silicium mono ou multicristallin, et qu'elles présentent une épaisseur comprise entre 1 µm et 250 µm.

Par ailleurs, les dimensions transversales considérées ici peuvent être des largeurs et/ou des longueurs.

Bien entendu, ces choix ne sont nullement limitatifs.

Afin de décrire les différentes configurations envisagées, on se réfère tout d'abord à la figure 3 qui illustre, en coupe, un premier exemple de réalisation d'un module photovoltaïque 1 conforme à l'invention.

Il est à noter que la figure 3 correspond à une vue du module photovoltaïque 1 avant l'étape de fabrication, notamment de lamination, du procédé selon l'invention. Une fois cette étape réalisée, notamment par lamination assurant un pressage à chaud et sous vide, les différentes couches sont en réalité au contact les unes aux autres, et notamment interpénétrées les unes dans les autres.

Le module photovoltaïque 1, ou plus précisément l'empilement destiné à former le module photovoltaïque 1 et réalisé selon un axe d'empilement vertical X, comporte ainsi une première couche 2 formant la face avant du module photovoltaïque 1 et destinée à recevoir un flux lumineux, une pluralité de cellules photovoltaïques 4 disposées côte à côte et reliées électriquement entre elles, et un ensemble encapsulant 3 (3a, 3b) la pluralité de cellules photovoltaïques 4.

Conformément à l'invention, et de manière commune aux exemples des figures 3 à 7, une structure composite 10 est présente pour former un cadre pour le module photovoltaïque 1, et plus particulièrement le cadre du module photovoltaïque, en remplacement du cadre en aluminium habituellement utilisé dans les modules photovoltaïques classiques.

Cette structure composite 10 comporte une couche intermédiaire 13 et un cadre de renfort composite 12, disposé au contact direct de la couche intermédiaire 13. Cette couche intermédiaire 13 est située entre le cadre de renfort composite 12 et l'ensemble formé par les cellules photovoltaïques 4 et l'ensemble encapsulant 3.

Le cadre composite 12 permet de rigidifier le module photovoltaïque 1. En particulier, la rigidité du cadre de renfort composite 12 est plus élevée en superposition de premières zones prédéterminées P, ici le contour périphérique P de la couche intermédiaire 13 dans l'exemple de la figure 3, qu'en superposition de deuxièmes zones prédéterminées N de la couche intermédiaire 13, ici une zone centrale N de la couche intermédiaire, qui est ici non recouverte par le cadre de renfort composite 12 dans l'exemple de la figure 3.

Par ailleurs, le cadre composite 12 présente un module de Young E₁₂ supérieur à 10 GPa à 25°C, par exemple compris entre 20 GPa et 100 GPa à 25°C, voire entre 80 GPa et 100 GPa à 25°C ou bien encore entre 20 GPa et 50 GPa à 25°C.

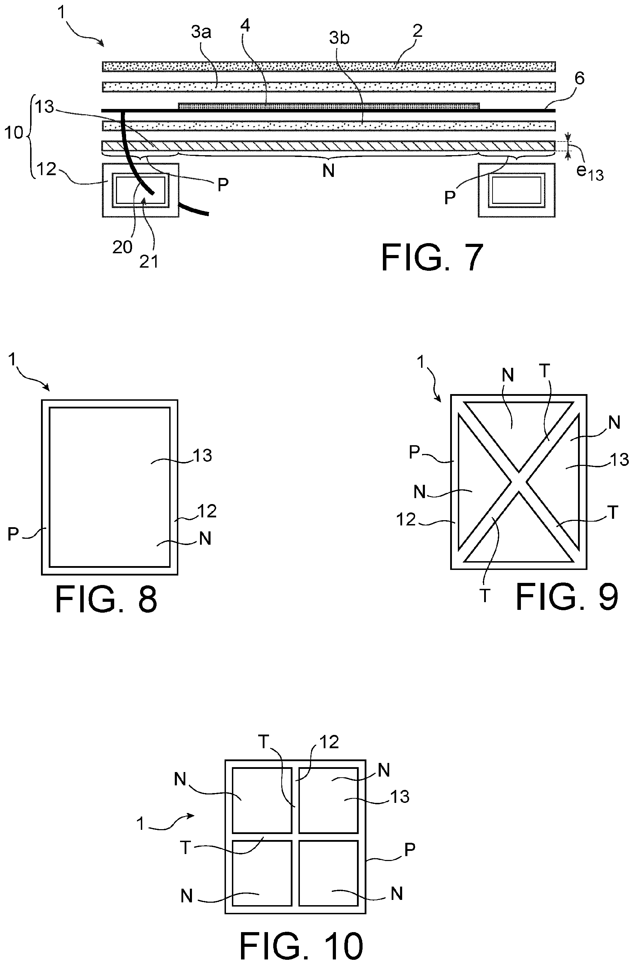

La couche intermédiaire 13 présente donc une ou plusieurs premières zones prédéterminées P, T (illustrées figures 9, 10 par exemple) qui sont destinées à être recouvertes par le cadre de renfort composite 12 avec des premières portions du cadre 12 de rigidité élevée, et également une ou plusieurs deuxièmes zones prédéterminées N qui sont destinées à être recouvertes par le cadre de renfort composite 12 avec des deuxièmes portions du cadre 12 de rigidité moins élevée ou bien encore destinées à ne pas être recouvertes par le cadre 12.

La figure 8 permet d'illustrer, selon une vue du dessous, la couche intermédiaire 13 de la structure composite 10 comprenant une deuxième zone centrale prédéterminée N non recouverte par le cadre de renfort composite 12 et une première zone périphérique prédéterminée P recouverte par le cadre de renfort composite 12 avec ainsi sa rigidité la plus élevée correspondant à la rigidité du cadre 12.

Il est à noter que, afin de favoriser la rigidité du module photovoltaïque 1, notamment dans le cas de modules de grandes dimensions, la couche intermédiaire 13 peut également comporter des zones transversales prédéterminées T sur lesquelles est superposé le cadre 12 avec des premières portions du cadre 12 de rigidité plus élevée.

Ces zones transversales T peuvent s'étendre d'un bord à l'autre de la couche intermédiaire 13 (comme illustré figure 10) ou d'un angle à l'autre de la couche intermédiaire 13 (comme illustré figure 9). Les zones transversales T peuvent former une croix de rigidification, par exemple avec deux zones transversales T s'étendant depuis les quatre angles de la couche intermédiaire 13 comme sur l'exemple de la figure 9, ou encore avec deux zones transversales T s'étendant perpendiculairement d'un bord à l'autre de la couche intermédiaire 13 comme sur l'exemple de la figure 10.

Les deuxièmes zones prédéterminées N de la couche intermédiaire 13 peuvent être non recouvertes par le cadre 12 ou recouvertes par des deuxièmes portions du cadre 12 de rigidité la moins élevée.

Il faut par ailleurs noter que la dimension transversale d₁₀ par rapport à l'axe d'empilement vertical X de la structure composite 10 est supérieure à la dimension transversale d₄ par rapport à l'axe d'empilement vertical X de la pluralité de cellules photovoltaïques 4.

Dans tous les exemples des figures 3 à 10, les dimensions transversales d₂ de la première couche 2, d₃ₐ de la couche avant 3a de l'encapsulant 3, d_{3b} de la couche arrière 3b de l'encapsulant 3 et dio de la structure composite 10 sont sensiblement identiques, tandis que la dimension transversale d₄ de la pluralité de cellules photovoltaïques 4 est plus faible. De plus, la structure composite 10 permet de définir la face arrière du module photovoltaïque 1.

Par ailleurs, la première couche 2, formant la face avant, comporte des fibres de verre imprégnées de résine polymère. Elle est ainsi sous la forme d'une couche composite transparente à base de tissus de fibres de verre imprégnés de résine polymère transparente et résistante au choc, et notamment sous la forme d'un seul pli.

La couche intermédiaire 13 et le cadre de renfort composite 12 sont au moins en partie formés par un matériau composite comprenant une résine polymère et des fibres, notamment des fibres de verre, de carbone, d'aramide et/ou des fibres naturelles, notamment de chanvre, de lin et/ou de basalte, notamment sous la forme de tissus, par exemple tissés, non tissés et/ou cousus, notamment sous la forme d'un ou plusieurs plis, par exemple entre 1 et 6 plis.

Avantageusement, et en particulier dans l'exemple de la figure 3, les matériaux constitutifs de la couche intermédiaire 13 et du cadre 12 sont identiques.

La résine polymère, utilisée pour imprégner les fibres, aussi bien pour la première couche 2, la couche intermédiaire 13 et le cadre de renfort composite 12 peut être choisie parmi : le polyuréthane (PU), le polypropylène (PP), l'époxy, le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE) et/ou l'éthylène propylène fluoré (FEP).

Une préimprégnation peut avoir lieu avant la mise en forme du module photovoltaïque 1, par exemple par lamination, ou l'imprégnation peut avoir lieu pendant l'assemblage, par exemple par injection de résine polymère au cours de l'assemblage.

Préférentiellement, dans tous les exemples de réalisation des figures 3 à 10, la couche intermédiaire 13 est par exemple constituée d'un matériau composite comprenant une résine polymère et un ou plusieurs tissus avec des fibres naturelles, notamment au moins un pli et avantageusement au moins deux plis. Avantageusement, la résine polymère apporte de l'adhésion entre les couches après assemblage.

Par ailleurs, dans l'exemple de la figure 3, le cadre de renfort composite 12 comporte une structure monolithique discontinue, formée à partir d'un ou plusieurs plis de fibres. Elle est par exemple constituée d'un ou plusieurs tissus avec des fibres de basalte, de verre ou de carbone, notamment un pli ou plusieurs plis. Elle est située en superposition de la première zone périphérique prédéterminée P de la couche intermédiaire 13, la deuxième zone centrale prédéterminée N de la couche intermédiaire 13 n'étant pas recouverte par le cadre de renfort composite 12.

Dans un exemple de réalisation, le cadre de renfort composite 12 et/ou la couche intermédiaire 13 peuvent utiliser des tissus avec des fibres de basalte, par exemple des tissus de type NCF (pour « Non Crimp Fabric » en anglais, soit du tissu multi axial cousu).

De façon générale, la structure composite 10 peut présenter une dimension transversale d₁₀, notamment une largeur, comprise entre 30 mm et 100 mm, et par exemple de l'ordre de 60 mm pour un module photovoltaïque 1 de dimensions 700 mm x 680 mm.

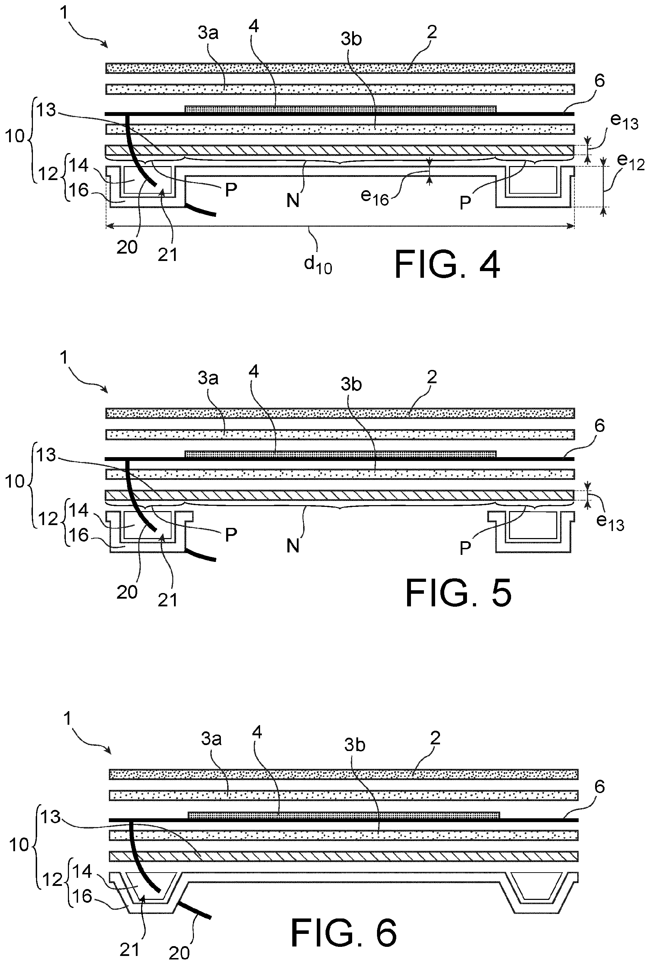

Les exemples de réalisation des figures 4 à 7 permettent d'illustrer plusieurs configurations pour la structure composite 10 sous la forme d'une structure multicouche. Alors, l'épaisseur e₁₂ du cadre 12 est plus élevée en superposition de la ou des premières zones prédéterminées P, T de la couche intermédiaire 13 que l'épaisseur en superposition de la ou des deuxièmes zones prédéterminées N de la couche intermédiaire 13.

En particulier, les exemples de réalisation des figures 4 à 6 illustrent une structure composite 10 sous la forme d'une structure de type sandwich. Elle comprend alors une couche principale formant l'âme 14 et des première et deuxième couches de recouvrement formant des couches de peau 13, 16, la première couche de peau étant formée par la couche intermédiaire 13, disposées de part et d'autre de l'âme 14 de sorte que l'âme 14 soit prise en sandwich entre les deux couches de peau 13, 16.

L'âme 14 de la structure composite 10 présente une faible rigidité, par exemple inférieure à 5 GPa, par exemple comprise entre 0,5 GPa et 5 GPa, tandis que les couches de peau 13, 16 présentent une rigidité importante, notamment de l'ordre de 20 GPa à 100 GPa, voire entre 80 GPa et 100 GPa ou bien encore entre 20 GPa et 50 GPa à 25°C.

L'âme 14 peut comporter du vide. Elle peut encore être par exemple formée par une structure de faible densité inférieure à 500 kg/m³, par exemple 100 kg/m³, notamment une structure alvéolaire telle qu'une mousse faible densité, par exemple en polyuréthane (PU), en polychlorure de vinyle (PVC) et/ou polytéréphtalate d'éthylène (PET), un nid d'abeilles, du bois, du balsa et/ou du liège.

Les couches de peau 13, 16 sont par exemple formées par un matériau composite comprenant une résine polymère et des fibres, notamment des fibres de verre, de carbone, d'aramide et/ou des fibres naturelles, notamment de basalte, notamment sous la forme de tissus, par exemple tissés, non tissés et/ou cousus, notamment sous la forme d'un ou plusieurs plis, par exemple entre 1 et 6 plis, préférentiellement 2 plis. Les couches de peau 13, 16 peuvent comporter différents types de matrices, par exemple thermodurcissables et/ou thermoplastiques.

Les épaisseurs e₁₃, e₁₆ des couches de peau 13, 16 peuvent être comprises entre 0,2 mm et 2 mm, étant préférentiellement de l'ordre de 0,5 mm.

La deuxième couche de peau 16 forme la face arrière du module photovoltaïque 1. La deuxième couche de peau 16 présente ainsi une dimension transversale par rapport à l'axe d'empilement vertical X qui est égale à la dimension transversale d₁₀ par rapport à l'axe d'empilement vertical X de la structure composite 10.

Comme visible sur les figures 4 et 6, l'âme 14 de la structure composite 10 est située en superposition de la première zone périphérique prédéterminée P de la couche intermédiaire 13 tandis que la deuxième zone centrale prédéterminée N de la couche intermédiaire 13 n'est pas recouverte par l'âme 14. En revanche, dans l'exemple de la figure 5, la deuxième zone centrale prédéterminée N de la couche intermédiaire 13 est recouverte par la zone centrale de la deuxième couche de recouvrement 16, présentant une rigidité plus faible que celle de l'ensemble formé par l'âme et les portions périphériques de la deuxième couche de recouvrement 16.

La structure de type sandwich ainsi formée est avantageuse en ce qu'elle permet d'augmenter l'inertie et la rigidité de la structure composite 10 en flexion, notamment jusqu'à un facteur de 30, tout en préservant la faible masse engendrée. En effet, une structure de type sandwich présente une rigidité en flexion proportionnelle au cube de son épaisseur. On peut donc, en augmentant l'épaisseur de l'âme 14, augmenter de manière significative son moment d'inertie en flexion et obtenir une augmentation considérable de la rigidité de la structure tout en minimisant l'accroissement de masse. Néanmoins, le choix de l'épaisseur de l'âme 14 est réalisé dans l'objectif d'une masse minimale pour les contraintes mécaniques demandées, notamment la résistance au cisaillement, à la flexion et/ou au choc.

De plus, la détermination des épaisseurs respectives des couches de peau 13, 16 et de l'âme 14 se fait de façon à résister aux moments fléchissant, au cisaillement, et aux contraintes axiales induites par les forces appliquées sur les éléments de construction de la structure de type sandwich. Les propriétés mécaniques et l'allègement sont typiquement les critères principaux intervenant dans le choix des constituants.

Dans les exemples de réalisation des figures 4 et 5, l'âme 14 est de section rectangulaire dans un plan comprenant l'axe vertical X, tandis que cette section est trapézoïdale dans l'exemple de réalisation de la figure 6.

Une section trapézoïdale permet de faciliter la mise en oeuvre des plis composites et la fermeture de la structure de type sandwich par rapport à l'extérieur.

Il est en outre à noter que lors de la mise en oeuvre, la surépaisseur du cadre de renfort composite 12 par rapport au reste de la structure composite 10 peut être compensée éventuellement par l'usage de feuilles de silicone, par exemple de type Mosite, afin de pouvoir appliquer une pression uniforme sur l'ensemble.

L'exemple représenté sur la figure 7 permet en outre d'illustrer une réalisation du cadre de renfort composite 12 sous la forme d'une structure de type tubulaire. Cette structure comporte un corps creux composite 12, qui est par exemple de section rectangulaire dans un plan comprenant l'axe vertical X. Ce corps creux composite 12 sous forme de tube définit ainsi une cavité interne remplie d'air. Ce cadre 12 peut être formé par un ou plusieurs profilés, notamment pultrudés et intégrés à la structure en cocuisson.

En outre, il faut noter qu'un ou plusieurs films de collage peuvent être intégrés entre les différentes couches décrites précédemment pour permettre une meilleure adhésion entre les différents matériaux afin de garantir une bonne performance de la structure réalisée au regard de la résistance, de la tenue à la chaleur, du vieillissement humide demandés, ainsi que des paramètres de mise en oeuvre du module lors de la fabrication.

De plus, dans les exemples des figures 4 à 7, un ou plusieurs câbles de connexion électrique 20 peuvent être reliés à un ou plusieurs conducteurs de liaison 6, notamment les rubans de cuivre étamé 6, permettant de relier les cellules 4 entre elles, et peuvent traverser l'âme 14 de la structure composite 10, soit traverser du vide ou de l'air, soit traverser le matériau constitutif de l'âme 14, par exemple une mousse, pouvant le cas échéant être aménagée pour permettre le passage du ou des câbles 20.

De cette façon, il est possible de réaliser la connexion électrique du module photovoltaïque 1 ou de relier plusieurs modules photovoltaïques ensemble sans avoir besoin d'utiliser une ou plusieurs boîtes de jonction comme selon les réalisations de l'art antérieur.

Par ailleurs, une ou plusieurs diodes de bypass 21, connectées au(x) câble(s) 20, peuvent également être intégrées dans l'âme 14 du fait de l'épaisseur de celle-ci permettant cette intégration.

Dans tous les exemples des figures 3 à 7, le module photovoltaïque 1 peut être obtenu par un procédé classique de lamination en une seule étape, par exemple par lamination à chaud sous vide à une température d'environ 150°C pendant environ 15 minutes, ou bien encore par un procédé de transformation utilisé pour les matériaux composites, notamment par infusion, moulage par transfert de résine (ou encore RTM pour « Resin Transfer Molding » en anglais) et/ou par consolidation de préimprégnés. Ainsi, on obtient avantageusement une structure composite 10 et un cadre 12 intégrés à l'intérieur du module photovoltaïque 1, permettant d'éviter le recours au cadre en aluminium usuel et ainsi d'alléger considérablement le poids surfacique du module tout en garantissant une rigidité suffisante.

A noter également que, dans les exemples des figures 5 et 7 pour lesquels le cadre en renfort composite 12 présente une discontinuité centrale, ses éléments constitutifs, notamment les renforts en Ω formés par la deuxième couche de recouvrement 16 de la figure 5, peuvent être formés par des pièces préfabriquées et rapportées sur la couche intermédiaire 13.

Bien entendu, l'invention n'est pas limitée à l'exemple de réalisation qui vient d'être décrit. Diverses modifications peuvent y être apportées par l'homme du métier.

En particulier, l'invention peut être mise en oeuvre pour des modules photovoltaïques plans mais également avec d'autres types de format, par exemple des modules courbes.

## Revendications

1. Module photovoltaïque (1) obtenu à partir d'un empilement, formé selon un axe d'empilement vertical (X), comportant au moins :
- une première couche (2) transparente formant la face avant du module photovoltaïque (1), destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4), **caractérisé en ce qu'**il comporte en outre :
- une structure composite (10) formant un cadre pour le module photovoltaïque (1), comportant au moins :
- une couche intermédiaire (13),
- un cadre de renfort composite (12), disposé au contact direct de la couche intermédiaire (13) située entre le cadre de renfort composite (12) et l'ensemble formé par la pluralité de cellules photovoltaïques (4) et l'ensemble encapsulant (3),
la structure composite (10) étant une structure de type sandwich, comprenant une couche principale formant l'âme (14) de la structure composite (10) et deux première (13) et deuxième (16) couches de recouvrement formant des couches de peau (13, 16), dont l'une est formée par la couche intermédiaire (13), disposées de part et d'autre de l'âme (14) de sorte que l'âme (14) est prise en sandwich entre les deux couches de peau (13, 16),
l'âme (14) de la structure composite (10) étant au moins en partie formée par une structure de faible densité inférieure à 500 kg/m³,
la rigidité du cadre de renfort composite (12) étant plus élevée en superposition d'une ou plusieurs premières zones prédéterminées (P, T) de la couche intermédiaire (13) que la rigidité en superposition d'une ou plusieurs deuxièmes zones prédéterminées (N) de la couche intermédiaire (13),
le cadre de renfort composite (12) présentant un module de Young (E₁₂) supérieur à 10 GPa à 25°C,
l'ensemble encapsulant (3) la pluralité de cellules photovoltaïques (4) étant situé au moins en partie entre ladite première couche (2) et ladite structure composite (10).

2. Module selon la revendication 1, **caractérisé en ce que** la ou les premières zones prédéterminées (P, T) comportent la périphérie (P) de la couche intermédiaire (13).

3. Module selon la revendication 2, **caractérisé en ce que** la ou les premières zones prédéterminées (P, T) comportent une ou plusieurs zones transversales (T) de la couche intermédiaire (13), s'étendant notamment d'un bord à un autre de la couche intermédiaire (13), perpendiculairement ou non, et/ou d'un angle à un autre de la couche intermédiaire (13), formant notamment une forme de croix de rigidification.

4. Module selon l'une des revendications précédentes, **caractérisé en ce que** la première couche (2), la couche intermédiaire (13) et/ou le cadre de renfort composite (12) sont au moins en partie formés par un matériau composite comprenant une résine polymère et des fibres, les fibres étant notamment des fibres de verre, de carbone, d'aramide et/ou des fibres naturelles, notamment de chanvre, de lin et/ou de basalte, et la résine polymère étant notamment choisie parmi : le polyuréthane (PU), le polypropylène (PP), l'époxy, le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le polychlorotrifluoroéthylène (PCTFE) et/ou l'éthylène propylène fluoré (FEP).

5. Module selon l'une quelconque des revendications précédentes, **caractérisé en ce que** le cadre de renfort composite (12) comporte une structure monolithique discontinue (12) en superposition de la ou des premières zones prédéterminées (P, T) de la couche intermédiaire (13), la ou les deuxièmes zones prédéterminées (N) de la couche intermédiaire (13) n'étant pas recouverte(s) par le cadre de renfort composite (12), le cadre de renfort composite (12) présentant notamment la même rigidité que celle de la couche intermédiaire (13) et étant notamment constitué par le même matériau que celui de la couche intermédiaire (13).

6. Module selon l'une quelconque des revendications 1 à 4, **caractérisé en ce que** la structure composite (10) comporte une structure multicouche (12), notamment avec une épaisseur (e₁₂) du cadre de renfort composite (12) plus élevée en superposition d'une ou plusieurs premières zones prédéterminées (P, T) de la couche intermédiaire (13) que l'épaisseur en superposition d'une ou plusieurs deuxièmes zones prédéterminées (N) de la couche intermédiaire (13).

7. Module selon l'une quelconque des revendications 1 à 6, **caractérisé en ce que** l'âme (14) de la structure composite (10) présente une faible rigidité, par exemple inférieure à 5 GPa, tandis que les couches de peau (13, 16) présentent une rigidité importante, notamment de l'ordre de 20 GPa à 100 GPa, à 25°C.

8. Module selon l'une quelconque des revendications 1 à 7, **caractérisé en ce que** l'âme (14) de la structure composite (10) est de section rectangulaire ou trapézoïdale dans un plan comprenant l'axe vertical (X).

9. Module selon l'une quelconque des revendications 1 à 8, **caractérisé en ce que** l'âme (14) de la structure composite (10) est au moins en partie formée par une structure alvéolaire telle qu'une mousse faible densité, par exemple en polyuréthane (PU), en polychlorure de vinyle (PVC) et/ou polytéréphtalate d'éthylène (PET), un nid d'abeilles, du bois, du balsa et/ou du liège, et **en ce que** les couches de peau (13, 16) sont au moins en partie formées par un matériau composite comprenant une résine polymère et des fibres.

10. Module selon l'une quelconque des revendications 1 à 8, **caractérisé en ce que** l'âme (14) de la structure composite (10) correspond à du vide.

11. Module selon l'une quelconque des revendications 1 à 10, **caractérisé en ce que** l'âme (14) de la structure composite (10) est située en superposition de la ou des première zones prédéterminées (P, T) de la couche intermédiaire (13), la ou les deuxièmes zones prédéterminées (N) de la couche intermédiaire (13) étant non recouvertes ou recouvertes par la deuxième couche de recouvrement (16), autre que la couche intermédiaire (13).

12. Module selon l'une quelconque des revendications 1 à 11, **caractérisé en ce qu'**il comporte un câble de connexion électrique (20) relié à un ou plusieurs conducteurs de liaison (6) reliant les cellules photovoltaïques (4) entre elles, et traversant l'âme (14) de la structure composite (10), éventuellement aménagée pour permettre le passage du câble de connexion électrique (20), de manière à permettre la connexion électrique du module photovoltaïque (1) et/ou le rattachement électrique à un autre module photovoltaïque.

13. Module selon la revendication 12, **caractérisé en ce que** l'âme de la structure composite (10) loge au moins une diode de bypass (21) connectée au câble de connexion électrique (20).

14. Module selon l'une quelconque des revendications 1 à 13, **caractérisé en ce que** le cadre de renfort composite (12) est une structure de type tubulaire, comprenant un corps creux composite (12), notamment de section rectangulaire ou carrée dans un plan comprenant l'axe vertical (X).

15. Procédé de réalisation d'un module photovoltaïque (1) selon l'une quelconque des revendications précédentes, à partir d'un empilement, formé selon un axe d'empilement vertical (X), comportant :
- une première couche (2) transparente formant la face avant du module photovoltaïque (1), destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4),
- une structure composite (10) formant un cadre pour le module photovoltaïque (1), comportant au moins :
- une couche intermédiaire (13),
- un cadre de renfort composite (12), disposé au contact direct de la couche intermédiaire (13) située entre le cadre de renfort composite (12) et l'ensemble formé par la pluralité de cellules photovoltaïques (4) et l'ensemble encapsulant (3),
la structure composite (10) étant une structure de type sandwich, comprenant une couche principale formant l'âme (14) de la structure composite (10) et deux première (13) et deuxième (16) couches de recouvrement formant des couches de peau (13, 16), dont l'une est formée par la couche intermédiaire (13), disposées de part et d'autre de l'âme (14) de sorte que l'âme (14) est prise en sandwich entre les deux couches de peau (13, 16),
l'âme (14) de la structure composite (10) étant au moins en partie formée par une structure de faible densité inférieure à 500 kg/m³,
la rigidité du cadre de renfort composite (12) étant plus élevée en superposition d'une ou plusieurs premières zones prédéterminées (P, T) de la couche intermédiaire (13) que la rigidité en superposition d'une ou plusieurs deuxièmes zones prédéterminées (N) de la couche intermédiaire (13),
le cadre de renfort composite (12) présentant un module de Young (E₁₂) supérieur à 10 GPa à 25°C,
l'ensemble encapsulant (3) la pluralité de cellules photovoltaïques (4) étant situé au moins en partie entre ladite première couche (2) et ladite structure composite (10),
le procédé comportant l'étape de fabrication du module photovoltaïque (1) par un procédé de lamination, d'infusion, de moulage par transfert de résine et/ou de consolidation de préimprégnés, de sorte à ce que le cadre de renfort composite (12) soit intégré à l'intérieur du module photovoltaïque (1).
